# EUROPÄISCHE PATENTANMELDUNG

(11) **EP 2 264 784 A2**
(43) Veröffentlichungstag der Anmeldung: **22.12.2010**
(21) Anmeldenummer: 10005129.1
(22) Anmeldetag: 17.05.2010
(51) Int. Cl.: H01L 31/052

(54) **Dünnschichtsolarzelle und Verfahren zur Herstellung**

(30) Priorität: 16.06.2009 DE 102009025428
(71) Anmelder: SCHOTT Solar AG, 55122 Mainz (DE)
(72) Erfinder: Knoll, Hartmut, Dr., 06749 Bitterfeld (DE); Renno, Markus, 07743 Jena (DE); Lechner, Peter, 85591 Vaterstetten (DE)

(57) **Zusammenfassung**

Die vorliegende Erfindung betrifft eine Dünnschichtsolarzelle sowie ein Verfahren zu deren Herstellung, wobei der rückseitige Schichtaufbau der Dünnschichtsolarzelle einen mehrschichtigen Aufbau aufweist umfassend eine metallische Haftschicht, eine Übergangsschicht sowie eine Ag-haltige Reflektorschicht und durch einen hohen Reflektionsgrad sowie eine gute Haftung des Schichtsystems ausgezeichnet ist.

## Beschreibung

Die vorliegende Erfindung betrifft eine Dünnschichtsolarzelle nach dem Oberbegriff des Hauptanspruchs sowie ein Verfahren zur Herstellung einer Dünnschichtsolarzelle.

Dünnschichtsolarzellen bestehen im allgemeinen aus einem transparenten Substrat, auf dem eine Schichtfolge abgeschieden wird umfassend eine transparente Frontelektrodenschicht, ein photovoltaisch aktives Schichtsystem, welches sich in der Regel aus einer oder mehreren Halbleiterschichten zusammensetzt, eine transparente, leitfähige Barriereschicht, sowie eine metallische Rückelektrodenschicht, welche gleichzeitig die Reflektorschicht darstellt, und welche einfallende Strahlung, welche beim ersten Durchlauf durch das photovoltaisch aktive Schichtsystem nicht absorbiert worden ist, in die Halbleiterschichten zurückreflektieren soll. Dünnschichtsolarzellen werden häufig abschnittweise serienverschaltet, was z.B. durch das Einbringen von Trennlinien in dem Schichtsystem sowie ein abschnittweise elektrische Verbinden von Front- und Rückelektrode bewirkt werden kann. Durch die abschließende Kontaktierung sowie die Verkapselung der Dünnschichtsolarzellen z.B. mit einer Einbettfolie und einer abschließenden Glasplatte entsteht schließlich ein photovoltaisches Modul.

Der rückseitige Schichtaufbau einer Dünnschichtsolarzelle, der sich an das photovoltaisch aktive Schichtsystem anschließt, umfasst in der Regel eine oxidische Barriereschicht, welche eine hohe Transparenz und eine elektrische Leitfähigkeit aufweist, und eine metallische Reflektorschicht, welche gleichzeitig den Rückkontakt der Dünnschichtsolarzelle darstellt. Es können weitere Schichten folgen, welche den Reflektor vor Umwelteinflüssen wie z.B. Feuchtigkeit schützen, oder aber auch die Lötbarkeit verbessern. Die oxidische Barriereschicht hat u. a. die Funktion einer Diffusionsbarriere und verhindert, dass Metallatome aus der Rückelektrodenschicht in die Siliziumschicht eindiffundieren oder migrieren, was zu einer starken Abnahme des Wirkungsgrades der Solarzelle führen würde.

Für die metallische Reflektorschicht wird häufig ein im sichtbaren Spektralbereich (VIS) und nahen infraroten Spektralbereich (NIR) gut reflektierender Metallfilm eingesetzt. Besondere Bedeutung kommt hierbei der Reflektion im NIR bis zu einer Wellenlänge von ca. 1100 nm zu, da aufgrund des Absorptionsverhaltens der halbleitenden Schichten insbesondere diese vom Bauelement photovoltaisch verwertbare Strahlung den Reflektor erreicht, während Strahlung mit einer Wellenlänge unterhalb von ca. 700 nm schon beim ersten Durchlauf durch die halbleitenden Schichten weitgehend absorbiert wird. Als Reflektormaterial ist das Metall Al relativ gut geeignet, wegen höherer Reflexionsvermögen im nahen Infrarotbereich sind aber Ag und auch Au prinzipiell noch besser geeignet. Die Dicke der Metallreflektorschicht beträgt in der Regel zwischen 100 und 500 nm. Au scheidet deshalb als Reflektorschicht in der Regel aus Kostengründen aus. Eine Al-Schicht ist zwar mit geringeren Kosten verbunden, jedoch weist Al nur einen mäßigen Reflektionsgrad im besonders relevanten NIR auf.

Ag weist zwar bei erschwinglichen Kosten einen hohen Reflexionsgrad auf, im Gegensatz zu einer Al-Schicht weist eine Ag-Schicht aber im allgemeinen nur eine geringe Haftung auf der oxidischen Barriereschicht auf. Eine geringe Haftung der Reflektorschicht stellt jedoch eine Gefahr für die langfristige Zuverlässigkeit des photovoltaischen Moduls dar. Insbesondere nach Eindringen von Feuchtigkeit kann die Reflektorschicht von der Zwischenschicht delaminieren und damit zu einem Versagen der Funktion des photovoltaischen Moduls führen. Ebenso kann es nach der Kontaktierung der Rückelektrode durch Anlöten von Kontaktverbindern zu Schichtausrissen kommen oder es kann bei der Einbringung der Trennlinien zur Serienverschaltung zu einer Flitterbildung kommen, welche zu Kurzschlüssen zwischen den serienverschalteten Bereichen führen kann. Die Verwendung eines Ag-Reflektors direkt auf der transparenten, leitfähigen Barriereschicht ist daher nicht empfehlenswert.

Zur Verbesserung der Haftung der Silber-Reflektorschicht wird nach dem Stand der Technik zwischen der Ag-Schicht und der transparenten, leitfähigen Barriereschicht daher noch eine dünne metallische Haftschicht z.B. aus Ti, Cr, Ni oder Mo verwendet. Diese Haftschicht führt jedoch im allgemeinen zu einer signifikanten Verschlechterung des Reflektionsgrades des Reflektors, insbesondere durch die neu generierten Grenzflächen zwischen oxidischer Barriereschicht und Haftschicht sowie zwischen Haftschicht und Reflektorschicht, aber auch durch Absorption. Der Rückgang des Reflektionsgrades des Reflektors durch die metallische Haftschicht beträgt über das solare Spektrum gemittelt ca. 2 - 5%.

Aufgabe der Erfindung ist es daher, ein auf einem Ag-Reflektor basierendes rückseitiges Schichtsystem einer Dünnschichtsolarzelle zur Verfügung zu stellen, welches sich neben möglichst guten, auf dem Ag-Reflektor basierenden Reflektionseigenschaften insbesondere im NIR durch eine ausreichend hohe Haftfestigkeit des Schichtsystems auszeichnet, sowie ein Verfahren zu der Herstellung einer Dünnschichtsolarzelle zur Verfügung zu stellen.

Die Aufgabe wird gelöst durch die unabhängigen Ansprüche. Bevorzugte Ausführungsformen werden in den Unteransprüchen angegeben.

Der Hauptanspruch bezieht sich auf eine Dünnschichtsolarzelle mit einem transparenten Substrat, auf dem eine transparente Frontelektrodenschicht, ein photovoltaisch aktives Schichtsystem, eine transparente, leitfähige Barriereschicht sowie ein rückseitiges Schichtsystem angeordnet sind, welches die rückseitige Elektrode und den Reflektor darstellt, und welches eine metallische Haftschicht und eine Ag-haltige Reflektorschicht umfasst.

Unter Dünnschichtsolarzelle im Sinne der Erfindung sind verschiedene Formen von Solarzellen zu verstehen, die sich im allgemeinen durch eine Schichtdicke des photovoltaisch aktiven Schichtsystems von maximal ca. 10 µm auszeichnen, wobei die Herstellung des photovoltaisch aktiven Schichtsystems im allgemeinen direkt auf einem günstig verfügbaren Substrat erfolgt und damit kein Wafer erforderlich ist. Es kann sich zum Beispiel um Einzel- oder Mehrfachstapelzellen (insb. Tandem- oder Triple-Junction-Stapelzellen) aus amorphem und / oder mikrokristallinem Halbleitermaterial handeln. Das photovoltaisch aktive Schichtsystem, in welchem die Umwandlung der optischen Energie in elektrische Energie erfolgt, kann auf dem Halbleitermaterial Si basieren, es kann sich jedoch auch um andere Materialsysteme wie CdTe oder Cu(In, Ga)(S, Se)₂, handeln. Die Dünnschichtsolarzelle kann ferner weitere Elemente z.B. zur Kontaktierung, sowie zur Rückseitenverkapselung, etc. umfassen.

Bei dem transparenten Substrat kann es sich um ein Kunststoffsubstrat z.B. aus Polycarbonat handeln, vorzugsweise handelt es sich aufgrund der höheren thermischen und chemischen Beständigkeit um ein Glassubstrat. Der Begriff transparent bezieht sich sowohl im Falle des Substrates als auch im Fall der Front- und Rückelektrode auf Strahlung im VIS sowie im NIR bis zu einer Wellenlänge von ca. 1100 nm und ist dahingehend zu verstehen, dass bezogen auf eine typisches solares Spektrum ein Großteil der einfallenden Strahlung von mindestens 50% in diesem Spektralbereich transmittiert wird. Das transparente Substrat kann unterschiedliche Materialstärken aufweisen und in Form einer Folie oder Platte vorliegen. Das transparente Substrat kann ferner eine mikrostrukturierte Oberfläche aufweisen oder es kann eine mikrostrukturierte, transparente Beschichtung aufweisen, wobei durch die Mikrostrukturierung eine Richtungsablenkung der einfallenden Strahlung bewirkt wird. Durch die Richtungsablenkung kann eine Vergrößerung der optischen Weges der einfallenden Strahlung durch den Absorber und damit eine Steigerung des Wirkungsgrades der Solarzelle bewirkt werden. Bei dieser mikrostrukturierten Schicht kann es sich zum Beispiel um eine Siliziumoxinitrid, SnO₂ oder ZnO Schicht handeln, wobei Siliziumoxinitrid durch die Formel x SiO₂ : (1-x) SiO₃N₄, mit x= 0...1 beschrieben werden kann. Die mikrostrukturierte Seite befindet sich vorzugsweise auf der dem Lichteinfall gegenüberliegenden Seite des transparenten Substrates und ist z.B. zwischen Substrat und transparenter Frontelektrode angeordnet.

Das transparente Substrat kann ferner auf der Seite des Lichteinfalls eine Antireflektionsbeschichtung aus einer oder mehreren Schichten aufweisen, welche die Reflektion der einfallenden Strahlung reduziert. Des weiteren können weitere Schichten zur Erhöhung der Beständigkeit gegenüber Umwelteinflüssen, insbesondere Feuchtigkeit, vorhanden sein.

Die sich anschließende transparente Frontelektrodenschicht kann z.B. eine TCO-Schicht aus SnO₂, ITO oder ZnO umfassen, wobei ZnO vorzugsweise mit Al, Ga oder B dotiert ist und SnO₂ und/oder ITO vorzugsweise mit F dotiert sind.

Auch innerhalb des Schichtsystems können Antireflektionsschichten vorhanden sein, um die Reflektionsverluste an den Grenzflächen zu verringern, z.B. zwischen dem transparenten Substrat und der transparenten Frontelektrodenschicht oder auch zwischen der transparenten Frontelektrodenschicht und dem halbleitenden Schichtsystem.

Auf die transparente Frontelektrodenschicht folgt im allgemeinen das photovoltaisch aktive Schichtsystem sowie das rückseitige Schichtsystem, welches im wesentlichen die Funktion der Rückelektrode sowie des Reflektors hat. Oft ist auf der Rückseite des eigentlichen Reflektors noch eine Schutzschicht vorhanden, welche diesen insbesondere während der Rückseitenkontaktierung aber auch im späteren Betrieb schützt, insbesondere vor Oxidation.

Die erfindungsgemäße Dünnschichtsolarzelle gemäß dem Oberbegriff des Hauptanspruches ist **dadurch gekennzeichnet, dass** zwischen der metallischen Haftschicht und der Ag-haltigen Reflektorschicht eine Übergangsschicht vorhanden ist, deren Zusammensetzung ausschließlich die Komponenten der metallischen Haftschicht sowie der Ag-haltigen Reflektorschicht umfasst. Im Vergleich zu einem Schichtsystem, welches eine scharf definierte Grenzfläche zwischen metallischer Haftschicht und Ag-haltiger Reflektorschicht aufweist, kann durch die Übergangsschicht eine verbesserte Haftung der Ag-haltigen Reflektorschicht erreicht werden, da die Schichten nicht übergangslos ineinander übergehen und die potentielle Schwachstelle der scharfen Grenzfläche vermieden wird.

Die metallische Haftschicht umfasst bevorzugt eines der Metalle Cu, Cr, Fe, Mn, Ni, Ti, V, Zn, Mo, Zr, Nb, W, Ta, Al, Sn oder eine Legierung dieser Metalle oder Edelstahl. Bei diesen Metallen handelt es sich um 3d-Elemente (Cu, Cr, Fe, Mn, Ni, Ti, V, Zn), 4d-Elemente (Mo, Zr, Nb) sowie 5d-Elemente (W, Ta) aus den Nebengruppen des Periodensystems, welche ähnliche Elektronenkonfigurationen aufweisen, sowie Al und Sn. Ebenso besteht Edelstahl mit dem Hauptbestandteil Fe, sowie häufig Cr, Ni hauptsächlich aus 3d-Elementen. Diese Metalle und Edelstahl zeichnen sich dadurch aus, dass sie stark zur Ausbildung von Oxidschichten neigen, dadurch im allgemeinen eine gute Haftung auf der transparenten, leitfähige Barriereschicht aufweisen und gleichzeitig in Verbindung mit der Übergangsschicht eine hohe Haftung der Ag-haltigen Reflektorschicht erreicht wird.

Bevorzugt besteht die metallische Haftschicht aus Cu. Cu zeichnet sich unter den genannten Metallen bei guten Ergebnissen, was die Haftungsverbesserung des Schichtsystems betrifft, außerdem durch sehr gute optische Eigenschaften aus, da es in dem besonders relevanten nahen Infrarotbereich (NIR) einen hohen Reflektionsgrad aufweist und eine Cu-Schicht den Reflektionsgrad des Reflektoraufbaus daher nur geringfügig verschlechtert.

Die metallische Haftschicht weist vorzugsweise eine Schichtdicke im Bereich von 1 nm bis 50 nm auf. Ist die Schichtdicke geringer, so erfüllt sie nur eingeschränkt die Funktion der verbesserten Schichthaftung. Wird die Schichtdicke größer gewählt, so kommt es zunehmend zu Reflektionsverlusten. Bei Schichtdicken von deutlich über 50nm übernimmt die metallische Haftschicht schließlich auch die Reflektorfunktion, da die einfallende Strahlung die Ag-haltige Reflektorschicht dann nicht mehr erreicht, allerdings mit einem geringeren Reflektionsgrad. Die Vorteile der hochreflektiven Ag-haltigen Reflektorschicht können dann nicht mehr realisiert werden. Besonders bevorzugt ist daher eine Schichtdicke der metallischen Haftschicht im Bereich von 2 nm bis 20 nm, wobei gleichzeitig gute Haftungseigenschaften sowie gute optische Eigenschaften erreicht werden.

Die Ag-haltige Reflektorschicht umfasst Ag. Sie kann auch aus einer Ag-haltigen Legierung oder vorzugsweise aus reinem Ag bestehen. Wesentlich ist das hohe Reflektionsverhalten, welches Ag sowohl im VIS als auch im IR aufweist. Bevorzugt wird eine reine Ag-Schicht eingesetzt.

Die Ag-haltige Reflektorschicht weist bevorzugt eine Schichtdicke von 50 nm bis 500 nm auf. Der Reflektionsgrad der Ag-haltigen Reflektorschicht für sichtbare Strahlung und NIR (nahes Infrarot) nimmt im Schichtdickenbereich unterhalb etwa 150 nm mit steigender Schichtdicke deutlich zu; für den Schichtdickenbereich um 200 nm werden nur noch geringe Steigerungen des Reflektionsgrades erreicht. Deutlich größere Schichtdicken bringen nur noch sehr geringe Steigerungen der Reflektion und sind daher nicht mehr wirtschaftlich.

Bevorzugt weist die Übergangsschicht eine sich senkrecht zu dieser Schicht ändernde Schichtzusammensetzung auf, wobei die Zusammensetzung der Übergangsschicht am Übergang zu den angrenzenden Schichten jeweils an die Zusammensetzung dieser Schichten angenähert ist. Die Übergangsschicht bewirkt also einen besonders weichen Übergang zwischen der metallischen Haftschicht und der Ag-haltigen Reflektorschicht.

Die erfindungsgemäße Übergangsschicht weist eine Schichtdicke im Bereich von 0,1 nm bis 20 nm, bevorzugt 0,5 nm bis 10 nm und besonders bevorzugt 2 nm bis 10 nm auf. Die Übergangsschicht bewirkt einen weichen Übergang zwischen der metallischen Haftschicht und der Ag-haltigen Reflektorschicht.

Die transparente, leitfähige Barriereschicht umfasst bevorzugt ein transparentes leitfähiges Oxid (TCO), wobei die Schichtdicke im Bereich von 10 nm bis 300 nm liegt. Die leitfähige Barriereschicht hat unter anderem die Funktion, eine Diffusion von metallischen Ionen in das photovoltaisch aktive Schichtsystem zu verhindern. Sie wirkt aber auch als Haftungsschicht, da die meisten als Reflektor geeigneten Schichten auf dem halbleitenden Material des photovoltaisch aktiven Schichtsystems nur eine geringe Haftung aufweisen. Eine Mindeststärke der TCO-Schicht von etwa 10 nm ist für die zuverlässige Barrierewirkung notwendig. Zu groß sollte die Schichtdicke allerdings nicht sein, da mit zunehmender Schichtdicke des TCO-Materials die Absorption der Lichtstrahlung in der TCO-Schicht und auch die Verluste bei der Stromleitung ansteigen. Die TCO-Schicht hat ferner die Wirkung einer Interferenzschicht. Eine optimale Gesamttransmission für das relevante solare Spektrum wird bei einer Schichtdicke von ca. 80nm erreicht. Bevorzugt umfasst die leitfähige Barriereschicht die Oxide SnO₂, ITO (Indiumzinnoxid) oder ZnO. Die leitfähige Barriereschicht kann ferner eine Dotierung aufweisen, wobei ZnO vorzugsweise mit Al, Ga oder B dotiert ist und SnO₂ und/oder ITO vorzugsweise mit F dotiert sind.

In einer bevorzugten Ausführungsform ist die Ag-haltige Reflektorschicht an ihrer der Übergangsschicht abgewandten Seite mit einer Schutzschicht versehen. Bei dieser Schutzschicht kann es sich zum Beispiel um eine Schicht aus einer NiV-Legierung handeln. Sie schützt den metallischen Reflektor zum einen während des Kontaktierungsprozesses durch Löten, zum anderen vor Oxidation, welche die optischen Eigenschaften des Reflektors negativ beeinflussen könnte.

Gegenstand der Erfindung ist ebenso ein Verfahren zur Herstellung einer Dünnschichtsolarzelle, welches unter anderem aber nicht ausschliesslich zur Herstellung einer Dünnschichtsolarzelle mit den Merkmalen der vorausgehenden Beschreibung eingesetzt werden kann. Die in der Beschreibung der erfindungsgemäßen Dünnschichtsolarzelle eingeführten strukturellen Bestandteile der Dünnschichtsolarzelle und deren bevorzugte Ausführungsformen gelten daher auch für die bei der Beschreibung des Verfahrens verwendeten Begriffe. Dies gilt für u. a. für das transparente Substrat, die transparente, leitfähige Frontelektrodenschicht, das photovoltaisch aktive Schichtsystem und die transparente, leitfähige Barriereschicht.

Die Herstellung der Dünnschichtsolarzelle kann bis zu der Abscheidung des rückseitigen Schichtsystems gemäß Stand der Technik erfolgen. Auf dem transparenten Substrat wird in der Regel zuerst die transparente, leitfähige Frontelektrodenschicht abgeschieden. Diese kann z.B. in einem Vakuumsputterprozess erfolgen. Anschließend wird das photovoltaisch aktive Schichtsystem aufgebracht, welches in der Regel aus mehreren Halbleiterschichten besteht, welche eine unterschiedliche Dotierung aufweisen. Als Beschichtungsverfahren für Dünnschicht-Silizium Solarzellen wird in der Regel das PECVD-Verfahren (Plasma Enhanced Chemical Vapour Deposition) verwendet, halbleitende Schichten vom Typ CdTe können auch durch physikalische Sputterverfahren abgeschieden werden. Im Anschluss daran wird in der Regel die transparente, leitfähige Barriereschicht abgeschieden. Des Weiteren kann der Herstellungsprozess vor der Abscheidung des rückseitigen Schichtsystems weitere Prozesse wie z.B. Beschichtungsprozesse zum Aufbringen von Antireflektionsschichten, Haftschichten oder auch mikrostrukturierte Schichten umfassen sowie Strukturierungsprozesse zur Unterteilung der Dünnschichtsolarzelle in mehrere Bereiche, welche schließlich durch Aufbringen des rückseitigen Schichtsystems serienverschaltet werden.

Aus diesen Prozessschritten wird im allgemeinen ein im Folgenden als vorbeschichtetes Substrat bezeichnetes Zwischenprodukt erhalten, welches zumindest das transparente Substrat, die transparente Frontelektrodenschicht , das photovoltaisch aktive Schichtsystem und die transparente, leitfähige Barriereschicht umfasst. Das vorbeschichtete Substrat liegt im allgemeinen in Form einer größeren Glasplatte mit einer Fläche von ca. 0,1 bis 6 m² mit einer ebenen Oberfläche und dem genannten Schichtsystem vor. Die Beschichtung des Substrates mit der metallischen Haftschicht, der Übergangsschicht sowie der Ag-haltigen Reflektorschicht erfolgt durch zwei Beschichtungsprozesse P1 und P2, welche so zueinander angeordnet sind, dass Sie eine gemeinsame Beschichtungsebene aufweisen, in welcher sich die zu beschichtende Oberfläche eines Substrates während der Beschichtung vorzugsweise befindet. Der Begriff der Beschichtungsebene ist hierbei nicht im Sinne einer mathematischen Ebene mit Nullausdehnung in Richtung der Flächennormalen zu verstehen. Vielmehr ist die Beschichtungsebene als der Niveaubereich zu verstehen, in welchen die Oberflächen der vorbeschichteten Substrate während des Beschichtungsprozesses etwa positioniert werden. Mechanische Toleranzen in der Fördereinrichtung sowie geringe Unplanheiten des vorbeschichteten Substrates führen im allgemeinen dazu, dass die Oberfläche des vorbeschichteten Substrates nicht exakt plan ist.

Bei dem erfindungsgemäßen Herstellverfahren wird auf dem vorbeschichteten Substrat in dem Beschichtungsprozess P1 mit einem flächigen Beschichtungsbereich B1 in der Beschichtungsebene in einem Beschichtungszeitraum T1 die metallische Haftschicht und in einem zweiten Beschichtungsprozess P2 mit einem flächigen Beschichtungsbereich B2 in der Beschichtungsebene in einem Beschichtungszeitraum T2 die Ag-haltige Reflektorschicht abgeschieden, wobei das erfindungsgemäße Herstellverfahren dadurch gekennzeichnet ist, dass sich die Beschichtungszeiträume T1 und T2 zumindest teilweise zeitlich überschneiden und die Beschichtungsbereiche B1 und B2 der Beschichtungsprozesse sich zumindest teilweise in einem Bereich B3 überschneiden. Die beiden Beschichtungsprozesse P1 und P2 sind so angeordnet, dass sie eine gemeinsame Beschichtungsebene aufweisen, in welcher sich die Oberfläche des vorbeschichteten Substrates während der Beschichtung im Wesentlichen befindet. In dieser Beschichtungsebene kann jedem Beschichtungsprozess ein flächiger, ebener Beschichtungsbereich Bereich B1 bzw. B2 zugeordnet werden, in welchem durch diesen Beschichtungsprozess eine Schicht abgeschieden wird. Innerhalb dieser Beschichtungsbereiche wird die Beschichtungsrate im allgemeinen nicht konstant sein, im allgemeinen fällt die Beschichtungsrate in den Randbereichen ab. Die Überlappung der beiden Beschichtungsbereiche stellt den Bereich B3 dar, welcher durch beide Beschichtungsprozesse gleichzeitig oder auch zeitlich versetzt beschichtet werden kann.

In einer bevorzugten Ausführungsform des Verfahrens wird zwischen der metallischen Haftschicht und der Ag-haltigen Reflektorschicht eine Übergangsschicht gebildet. Die Übergangsschicht entsteht dabei durch die erfindungsgemäße Überschneidung der Beschichtungsbereiche sowie die zeitliche Überschneidung der Beschichtungszeiträume. Das bedeutet insbesondere, dass der Übergangsschicht kein eigener Beschichtungsprozess zugeordnet ist, sondern dass die Übergangsschicht durch die Beschichtungsprozesse P1 und P2 in dem Bereich B3 mit erzeugt wird. Auch ein separater Beschichtungsprozess wäre zur Erzeugung einer Übergangsschicht möglich, was jedoch mit deutlich höherem Aufwand verbunden wäre und daher keine bevorzugte Ausführungsform darstellt.

Das erfindungsgemäße Verfahren ist geeignet, Übergangsschichten mit den im Rahmen der Dünnschichtsolarzelle beschriebenen bevorzugten Merkmalen herzustellen, welche für das Verfahren ebenfalls beansprucht werden. Hierzu gehören die Schichtdicken und die Zusammensetzungen der Übergangsschicht, sowie insbesondere die Tatsache, dass die Übergangsschicht bevorzugt eine sich senkrecht zu der Schicht ändernde Zusammensetzung aufweist, wobei die Zusammensetzung der Übergangsschicht am Übergang zu den angrenzenden Schichten jeweils an die Zusammensetzung dieser Schichten angenähert ist.

In einer bevorzugten Ausführungsform des Verfahrens wird das vorbeschichtete Substrat in einer Förderrichtung gefördert, so dass dessen Oberfläche die Beschichtungsbereiche B1 und B2 der Beschichtungsprozesse sowie den Bereich B3 durchläuft, in dem sich die beiden Bereich B1 und B2 überschneiden, wobei das vorbeschichtete Substrat vorzugsweise mit einer konstanten Geschwindigkeit gefördert wird. Dabei sind die Beschichtungsprozesse bevorzugt so angeordnet, dass die Beschichtungsbereiche B1 und B2 in der Beschichtungsebene in der Förderrichtung betrachtet hintereinander angeordnet sind und der Überschneidungsbereich B3 in seiner flächigen Ausdehnung zwischen 1 bis 60 % der Fläche des Beschichtungsbereiches B1 beträgt. Durch die konstante Geschwindigkeit wird ein stationärer Prozess mit optimaler Effizienz ermöglicht.

In einer weiteren bevorzugten Ausführung des Verfahren sind die Beschichtungsprozesse P1 und P2 während der Beschichtung eines vorbeschichteten Substrates dauerhaft in Betrieb und der Gesamtprozess ist im wesentlichen stationär. Die stationäre Prozessführung hat im Vergleich zu der sequentiellen Durchführung der Beschichtungsprozesse P1 und P2 mit einer zeitlichen Änderung der Abscheiderate der Beschichtungsprozesse zahlreiche Vorteile. Bei einem konstanten Betrieb der Beschichtungsprozesse stellt sich ein Gleichgewichtszustand z.B. mit konstanter Temperatur der Sputtertargets ein, so dass eine konstante Abtragsrate erreicht wird. Die stationäre Prozessführung wirkt sich daher positiv auf die Stabilität und die Kontrollierbarkeit des Gesamtprozesses, auf die Qualität der Dünnschichtsolarzellen, sowie insbesondere auf den Mengendurchsatz aus, da es keine prozessbedingten Beschichtungspausen gibt. Die vorbeschichteten Substrate liegen normalerweise in Plattenform endlicher Länge vor, wodurch der Gesamtprozess streng genommen nicht stationär sondern einen periodischen Charakter aufweist. Bezüglich der Prozessführung des Gesamtprozesses spielt diese Diskontinuität jedoch keine Rolle, so dass der Prozess in diesem Sinne als im wesentlichen stationär betrachtet werden kann.

In einer bevorzugten Ausführung des Verfahrens weisen die in der Beschichtungsebene liegenden Beschichtungsbereiche B1 und B2 jeweils eine längliche, verrundete Geometrie auf, und die Ausdehnung dieser Beschichtungsbereiche B1 und B2 quer zur Förderrichtung entspricht im wesentlichen der Ausdehnung des vorbeschichteten Substrates quer zur Förderrichtung. Die Beschichtungsbereiche B1 und B2 können dabei die Ausdehnung des vorbeschichteten Substrates quer zur Förderrichtung geringfügig übersteigen, was das Erreichen einer gleichmäßig konstanten Schichtdicke von der Mitte bis zum Randbereich des zu beschichtenden Substrates unterstützen kann. Eine entsprechende Auslegung der Beschichtungsbereich ist in der Regel notwendig, da bei vielen Beschichtungsprozessen die Beschichtungsrate nicht im gesamten Beschichtungsbereich konstant ist, sondern zu den Rändern des Beschichtungsbereiches hin abfällt.

In einer bevorzugten Ausführung des Verfahrens weist entsprechend der Bereich B3 ebenfalls eine längliche, verrundete Geometrie auf und die Ausdehnung dieses Bereichs B3 quer zur Förderrichtung entspricht im wesentlichen der Ausdehnung des vorbeschichteten Substrates quer zur Förderrichtung.

In einer bevorzugten Ausführungsform des Verfahrens werden die Beschichtungsprozesse P1 und P2 innerhalb einer evakuierbaren Prozesskammer durchgeführt. Vakuumbeschichtungsprozesse sind für die Abscheidung der metallischen Schichten besonders geeignet, insbesondere wird eine Oxidation durch eine sauerstoffarme Atmosphäre vermieden.

In einer bevorzugten Ausführungsform des Verfahrens handelt es sich bei einem oder beiden Beschichtungsprozessen P1 und P2 um ein PVD (Physical Vapour Deposition)-Beschichtungsverfahren, bevorzugt um Magnetronsputtern. Mit diesem Beschichtungsverfahren lassen sich besonders gut großflächige, verunreinigungsarme Beschichtungen gleichmäßiger Schichtdicke herstellen. Vorzugsweise wird eine um ihre Längsachse rotierende Rohrkathode als Sputtertarget verwendet. Dadurch können störende Effekte wie insbesondere eine ungleichmäßige Schichtdicken im Randbereich der Beschichtung im Vergleich mit planaren Targets deutlich reduziert werden.

In einer bevorzugten Ausführungsform des Verfahrens wird als Sputtergas ein Edelgas oder ein Edelgasgemisch eingesetzt.

In einer weiteren möglichen Ausführungsform des Verfahrens stimmen die Beschichtungsbereiche B1 und B2 im wesentlichen überein, wobei das erfindungsgemäße rückseitige Schichtsystem dann durch eine zeitlich versetzte Durchführung der Beschichtungsprozesse P1 und P2 mit einer zeitlichen Überlappung der Beschichtungszeiträume T1 und T2 erzeugt werden kann. In diesem Fall unterliegt das vorbeschichtete Susbtrat vorzugsweise keiner Relativbewegung zu den Beschichtungsbereichen, ist also ortsfest. Diese Ausführungsform des Herstellverfahrens ist jedoch nicht bevorzugt, da der Prozess nicht stationär ist und auch keinen optimalen Mengendurchsatz aufweist.

Im folgenden wird die erfindungsgemäße Dünnschichtsolarzelle sowie das erfindungsgemäße Herstellverfahren in den Figuren 1 bis 3 näher erläutert.

Dabei zeigen
- Figur 1:: Schematische Darstellung des Schichtsystems einer Dünnschichtsolar- zelle gemäß Stand der Technik
- Figur 2:: Schematische Darstellung des rückseitigen Schichtsystems einer erfin- dungsgemäßen Dünnschichtsolarzelle mit angrenzenden Schichten
- Figur 3:: Schematische Darstellung der stationären Ausführungsform des Her- stellverfahrens mit den simultanen Beschichtungsprozesse P1 und P2 und mit Bewegung des vorbeschichteten Substrates

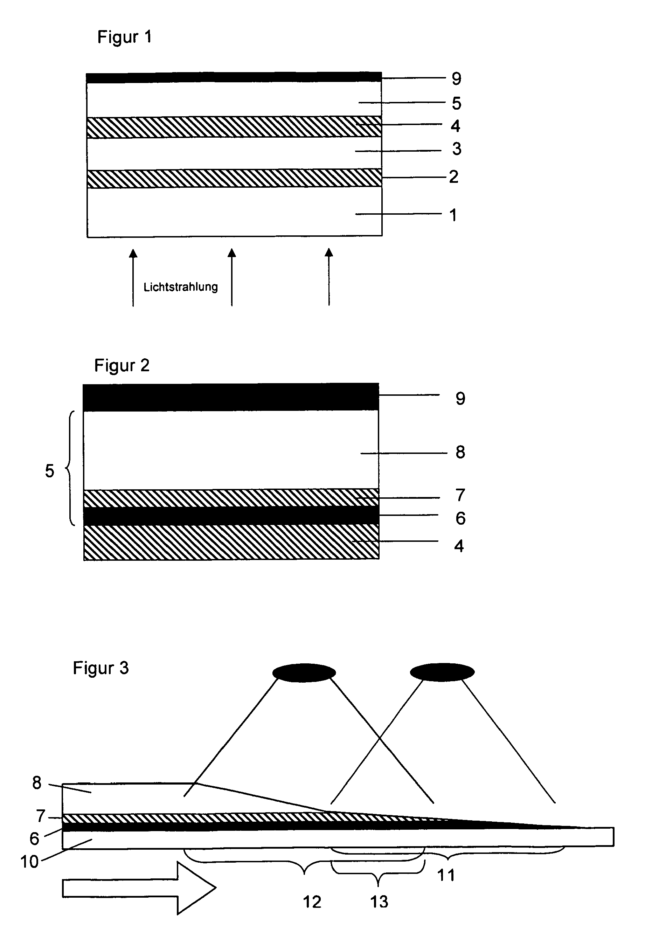

Die Schichtdicken sind in den Figuren nicht maßstäblich dargestellt. Ferner können noch weitere Schichten in dem Aufbau vorhanden sind, die für die Darstellung der Erfindung nicht von unmittelbarer Bedeutung sind und daher nicht dargestellt sind. Ebenso wird auf eine detaillierte Darstellung der Unterstruktur des photovoltaisch aktiven Schichtsystems (3) sowie des vorbeschichteten Substrates (10) in Figur 3 verzichtet.

Figur 1 zeigt dabei schematisch den Aufbau einer Dünnschichtsolarzelle gemäß Stand der Technik, wobei auf einem transparenten Substrat (1) die transparente, leitfähige Frontelektrodenschicht (2), das photovoltaisch aktive Schichtsystem (3), die transparente leitfähige Barriereschicht (4) sowie das rückseitige Schichtsystem (5) angeordnet sind, welches im Stand der Technik in der Regel lediglich eine metallische Reflektorschicht z.B. aus Al umfasst, welche gleichzeitig die Rückelektrode darstellt, sowie eine Schutzschicht (9).

Figur 2 zeigt schematisch den Aufbau des rückseitigen Schichtsystems (5) einer erfindungsgemäßen Dünnschichtsolarzelle mit den angrenzenden Schichten, wobei das rückseitige Schichtsystem (5) die metallische Haftschicht (6) die Übergangsschicht (7), die Ag-haltige Reflektorschicht (8), sowie eine Schutzschicht (9) umfasst.

In Figur 3 ist eine bevorzugte stationäre Ausführungsform des Herstellverfahrens der erfindungsgemäßen Dünnschichtsolarzelle bzw. des erfindungsgemäßen rückseitigen Schichtsystems mit den simultanen Beschichtungsprozesse P1 und P2 schematisch dargestellt, wobei das vorbeschichtete Substrat, welches bereits die transparente, leitfähige Frontelektrodenschicht (2), das photovoltaisch aktive Schichtsystem (3) und die transparente leitfähige Barriereschicht (4) umfasst, vorzugsweise in einer Vakuumkammer die Beschichtungsbereiche B1 (11), B3 (13) und den Beschichtungsbereich B2 (12) vorzugsweise mit konstanter Geschwindigkeit durchläuft. Jede Stelle des vorbeschichteten Substrates wird so zuerst mit der metallischen Haftschicht (6), der Übergangsschicht (7) und der Ag-haltigen Reflektorschicht (8) beschichtet.

Die vorteilhaften Eigenschaften der Erfindung werden an dem folgenden Ausführungsbeispiel näher erläutert:

| | |
|---|---|
| Transparentes Substrat: | Substratglas |
| Transparente Frontelektrodenschicht: | F-dotiertes SnO₂ |
| PV-aktives Schichtsystem: | Typ a-Si, pin-pin-Struktur |
| transparente leitfähige Barriereschicht: | ZnO, 80nm |
| metallische Haftschicht | Cu, Schichtdicke ca. 7 nm |
| Übergangsschicht | Cu-Ag, Schichtdicke ca. 0,5 nm |
| Ag-haltige Reflektorschicht | Ag, Schichtdicke 190 nm |

Für die Herstellung dieses Schichtsystems wurden auf dem transparenten Substratglas, welches bereits eine transparente Frontelektrodenschicht aufweist, mittels PECVD das photovoltaisch aktive a-Si-Schichtsystem (Si in amorpher Struktur) mit einer pin-pin Struktur abgeschieden, anschließend wurde eine ca. 80 nm starke ZnO-Schicht abgeschieden, welche die transparente leitfähige Barriereschicht darstellt. Die Abscheidung des erfindungsgemäßen rückseitigen Schichtsystems erfolgte bei einem Druckbereich von 1.10⁻⁴ mbar bis 1·10⁻³ mbar in einer Vakuumprozesskammer, durch welche das vorbeschichtete Substrat während des Beschichtungsprozesses mit konstanter Geschwindigkeit auf Rollen hindurchgefördert wurde. Entlang der Förderstrecke durchlief das vorbeschichtete Substrat dabei die Beschichtungsbereiche von zwei Magnetron-Sputterprozessen, welche jeweils ein rohrförmiges Sputtertarget (Rohrkathoden) aufweisen. Die Rohrkathoden der beiden Sputterprozesse, deren Längsachsen parallel zueinander und quer zur Förderrichtung ausgerichtet sind, befanden sich dabei in einem Abstand von ca. 80 mm von der Beschichtungsebene und wiesen untereinander einen Abstand von ca. 190 mm auf, so dass ein räumlicher Überlapp der beiden Beschichtungsbereiche vorhanden ist. Die Energiedichte auf den rohrförmigen Sputtertargets, welche ein Maß für die Abtragsrate der Sputtertargets und damit für die Beschichtungsrate darstellt, lag im ersten Sputterprozess für die Erzeugung der Cu-Schicht bei ca. 1W/cm², im zweiten Sputterprozess für die Erzeugung der Ag-Schicht bei ca. 10 W/cm², woraus die unterschiedlichen Schichtdicken der Cu- und der Ag-Schicht resultieren. In dem ersten Sputterprozess wurde eine Cu-Schicht mit einer Schichtdicke von ca. 7 nm abgeschieden, in dem zweiten Sputterprozess wurde eine Ag-Schicht mit einer Schichtdicke von ca. 190 nm abgeschieden, wobei zwischen der Cu- und der Ag-Schicht die Übergangsschicht erzeugt wurde. Des weiteren wurde die Ag-Schicht mit einer ca. 75 nm dicken NiV-Schicht versehen.

Zum Nachweis der erfindungsgemäßen Eigenschaften wurden zum Vergleich analog dem beschriebenen Herstellungsprozess Dünnschichtsolarzellen hergestellt, wobei jedoch die Cu- und die Ag-Schicht separat abgeschieden worden sind, so dass keine Übergangsschicht erzeugt wird. Dazu wurde in einem ersten Schritt nur die Cu-Schicht auf dem vorbeschichteten Substrat abgeschieden, und in einem zweiten Schritt wurde anschließend ohne zeitliche Überlappung die Ag-Schicht abgeschieden.

Für die Ermittlung der Haftfestigkeit wurden Metallbändchen mit einer Breite von ca. 5 mm auf der Schutzschicht angelötet, über welche senkrecht zum Schichtaufbau eine Zugkraft eingeleitet wurde. Die Zugkraft wurde langsam erhöht, bis das Metallbändchen sich zusammen mit einem Teil des Schichtsystems in Form eines Streifens von dem Substrat ablöste. Dabei wurde die kritische Zugkraft ermittelt, bei welcher die Ablösung der Schichten einsetzt. Erfahrungsgemäß sollte die Abzugskraft in diesem Test einen Mindestwert von ca. 4 N aufweisen. Für die erfindungsgemäßen hergestellten Dünnschichtsolarzellen erreichten 94,2% einen ausreichenden Wert der Abzugskraft von mindestens 4 N. Für die Vergleichsproben ohne Übergangsschicht erreichten hingegen nur 92,5 % einen ausreichenden Wert der Abzugskraft von mindestens 4 N.

Die Reflektionseigenschaften des erfindungsgemäßen rückseitigen Schichtsystems wurden mit einem Reflektionsspektrometer bestimmt. Um den optischen Einfluss des rückseitigen Schichtsystems möglichst genau bestimmen zu können, wurden spezielle Proben hergestellt, in welchen der Rückkontakt (ZnO, Cu, Cu-Ag-Zwischenschicht, Ag, NiV) auf einem Glas-Substrat bzw. zur besseren optischen Anpassung des Rückreflektors an das Silizium auf einem Glassubstrat mit einer 30 nm dicken Schicht aus amorphem Silizium deponiert wurde.

Anhand der optischen Messungen wurde zum einen belegt, dass eine separat vor der Ag-Schicht abgeschiedene Cu-Schicht von ca. 6nm Dicke nur zu einer sehr geringen Abnahme des spektralen Reflektionsgrades des Ag-Reflektors mit Cu-Haftschicht im Vergleich zu einem Reflektor ohne Cu-Haftschicht führt. Das Cu führt lediglich in den nichtrelevanten Spektralbereichen unterhalb 600 nm und oberhalb 1100 nm zu einem signifikanten Rückgang der Reflektion von mehr als 1 %, während in dem relevanten Spektralbereich von ca. 700 nm bis 1100 nm kein signifikanter Reflektionsrückgang von mehr als 1 % feststellbar war.

Des Weiteren wurde anhand optischer Messungen belegt, dass der spektrale Reflektionsgrad des erfindungsgemäßen Reflektors mit Übergangsschicht in dem Spektralbereich 700 nm bis 1100 nm ebenfalls nicht signifikant von einem Reflektor (Cu-Übergangsschicht-Ag) ohne Übergangsschicht abweicht.

Der spektrale Reflektionsgrad des erfindungsgemäßen Reflektors entspricht also im Rahmen der Messgenauigkeiten (<1%) im relevanten Spektralbereich dem eines reinen Ag-Reflektors ohne Übergangsschicht, welcher aufgrund der Haftungsprobleme nicht eingesetzt werden kann.

Zusammenfassend kann festgestellt werden, dass die erfindungsgemäße Dünnschichtsolarzelle in dem Spektralbereich 700 nm bis 1100 nm die Vorteile des hohen Reflektionsgrades eines Ag-haltigen Reflektors besitzt und gleichzeitig eine hohe Haftung des gesamten Schichtsystems, insbesondere des Ag-Reflektors aufweist. Die hohe Haftung wird in besonders vorteilhafter Weise durch eine sehr dünne metallische Haftschicht sowie eine Übergangsschicht zwischen der metallischen Schicht und der Ag-haltigen Reflektorschicht erreicht, die in einem simultanen Beschichtungsprozess der Ag-haltigen Reflektorschicht und der metallischen Haftschicht abgeschieden wird und deren Herstellung daher keines zusätzlichen Prozessschrittes bedarf. Als metallische Haftschicht hat sich insbesondere Cu aufgrund seiner guten Reflektionseigenschaften im relevanten Spektralbereich als hervorragend geeignet herausgestellt. Das erfindungsgemäße rückseitige Schichtsystem weist hervorragende Reflektionseigenschaften sowie auch sehr guten Haftungseigenschaften auf.

### Bezugszeichenliste

- 1: transparentes Substrat
- 2: transparente Frontelektrodenschicht
- 3: photovoltaisch aktives Schichtsystem
- 4: transparente, leitfähige Barriereschicht
- 5: rückseitiges Schichtsystem
- 6: metallische Haftschicht
- 7: Übergangsschicht
- 8: Ag-haltige Reflektorschicht
- 9: Schutzschicht
- 10: vorbeschichtetes Substrat
- 11: Beschichtungsbereich B1
- 12: Beschichtungsbereich B2
- 13: Bereich B3

## Patentansprüche

1. Dünnschichtsolarzelle mit einem transparenten Substrat (1), auf dem angeordnet sind eine transparente Frontelektrodenschicht (2), ein photovoltaisch aktives Schichtsystem (3), eine transparente, leitfähige Barriereschicht (4), sowie ein rückseitiges Schichtsystem (5), welches eine metallische Haftschicht (6) und eine Ag-haltige Reflektorschicht (8) umfasst, **dadurch gekennzeichnet, dass**
zwischen der metallischen Haftschicht (6) und der Ag-haltigen Reflektorschicht (8) eine Übergangsschicht (7) vorhanden ist, deren Zusammensetzung ausschließlich Komponenten der metallischen Haftschicht (6) und der Ag-haltigen Reflektorschicht (8) umfasst.

2. Dünnschichtsolarzelle nach dem vorhergehenden Anspruch, wobei die metallische Haftschicht (6) eines der Metalle Cu, Cr, Fe, Mn, Ni, Ti, V, Zn, Mo, Zr, Nb, W, Ta, Al, Sn oder eine Legierung dieser Metalle oder Edelstahl umfasst.

3. Dünnschichtsolarzelle nach mindestens einem der Ansprüche 1 bis 2, wobei die metallische Haftschicht (6) im wesentlichen aus Cu besteht.

4. Dünnschichtsolarzelle nach mindestens einem der Ansprüche 1 bis 3, wobei die metallische Haftschicht (6) eine Schichtdicke im Bereich von 1 nm bis 50 nm, bevorzugt 2 nm bis 20 nm aufweist.

5. Dünnschichtsolarzelle nach mindestens einem der Ansprüche 1 bis 4, wobei die Ag-haltige Reflektorschicht (8) Ag umfasst, aus einer Ag-haltigen Legierung oder vorzugsweise aus reinem Ag besteht.

6. Dünnschichtsolarzelle nach mindestens einem der Ansprüche 1 bis 5, wobei die Ag-haltige Reflektorschicht (8) eine Schichtdicke im Bereich von 50 nm bis 500 nm aufweist.

7. Dünnschichtsolarzelle nach mindestens einem der Ansprüche 1 bis 6, wobei die Übergangsschicht (7) eine sich senkrecht zu dieser Schicht ändernde Zusammensetzung aufweist, wobei die Zusammensetzung der Übergangsschicht (7) am Übergang zu den angrenzenden Schichten (6) und (8) jeweils an die Zusammensetzung dieser Schichten angenähert ist.

8. Dünnschichtsolarzelle nach mindestens einem der Ansprüche 1 bis 7, wobei die Schichtdicke der Übergangsschicht im Bereich von 0,1 nm bis 20 nm, bevorzugt 0,5 nm bis 10 nm und besonders bevorzugt 2 nm bis 10 nm liegt.

9. Dünnschichtsolarzelle nach mindestens einem der Ansprüche 1 bis 8, wobei die transparente, leitfähige Barriereschicht (4) ein transparentes leitfähiges Oxid (TCO) umfasst, und die Schichtdicke im Bereich von 10 nm bis 300 nm liegt.

10. Dünnschichtsolarzelle nach mindestens einem der Ansprüche 1 bis 9, wobei die transparente, leitfähige Barriereschicht (4) SnO₂, ITO (Indiumzinnoxid) oder ZnO umfasst.

11. Dünnschichtsolarzelle nach mindestens einem der Ansprüche 1 bis 10, wobei die transparente, leitfähige Barriereschicht (4) eine Dotierung aufweist, wobei ZnO vorzugsweise mit Al oder Ga oder B dotiert ist und SnO₂ und/oder ITO vorzugsweise mit F dotiert sind.

12. Dünnschichtsolarzelle nach mindestens einem der Ansprüche 1 bis 11, wobei die Ag-haltige Reflektorschicht (8) an ihrer der Übergangsschicht (7) abgewandten Seite mit einer Schutzschicht (9) versehen ist.

13. Verfahren zur Herstellung einer Dünnschichtsolarzelle, wobei auf einem vorbeschichteten Substrat (10),
welches zumindest ein transparentes Substrat (1), eine transparente Frontelektrodenschicht, ein photovoltaisch aktives Schichtsystem (3) und eine transparente, leitfähige Barriereschicht (4) umfasst,
eine metallische Haftschicht (6) in einem Beschichtungsprozess P1 mit einem flächigen Beschichtungsbereich B1 (11) in einer Beschichtungsebene in einem Beschichtungszeitraum T1 abgeschieden wird und eine Ag-haltige Reflektorschicht (8) in einem zweiten Beschichtungsprozess P2 mit einem flächigen Beschichtungsbereich B2 (12) in der Beschichtungsebene in einem Beschichtungszeitraum T2 abgeschieden wird, **dadurch gekennzeichnet, dass**
sich die Beschichtungszeiträume T1 und T2 zumindest teilweise zeitlich überschneiden und die Beschichtungsbereiche B1 (11) und B2 (12) der Beschichtungsprozesse in der Beschichtungsebene sich zumindest teilweise in einem Bereich B3 (13) überschneiden.

14. Verfahren nach Anspruch 13, wobei zwischen der metallischen Haftschicht (6) und der Ag-haltigen Reflektorschicht (8) eine Übergangsschicht (7) gebildet wird.

15. Verfahren nach mindestens einem der Ansprüche 13 und 14, wobei die metallische Haftschicht (6) eines der Metalle Cu, Cr, Fe, Mn, Ni, Ti, V, Zn, Mo, Zr, Nb, W, Ta, Al, Sn oder eine Legierung dieser Metalle oder Edelstahl umfasst.

16. Verfahren nach mindestens einem der Ansprüche 13 bis 15, wobei die metallische Haftschicht (6) im wesentlichen aus Cu besteht.

17. Verfahren nach mindestens einem der Ansprüche 13 bis 16, wobei die metallische Haftschicht (6) eine Schichtdicke im Bereich von 1 nm bis 50 nm, bevorzugt 2 nm bis 20 nm aufweist.

18. Verfahren nach mindestens einem der Ansprüche 13 bis 17, wobei die Ag-haltige Reflektorschicht (8) Ag umfasst, aus einer Ag-haltigen Legierung oder vorzugsweise aus reinem Ag besteht.

19. Verfahren nach mindestens einem der Ansprüche 13 bis 18, wobei die Ag-haltige Reflektorschicht (8) eine Schichtdicke im Bereich von 50 nm bis 500 nm aufweist.

20. Verfahren nach Anspruch 14 und mindestens einem der Ansprüche 13 bis 19, wobei die Übergangsschicht (7) eine sich senkrecht zu dieser Schicht ändernde Zusammensetzung aufweist und wobei die Zusammensetzung der Übergangsschicht (7) am Übergang zu den angrenzenden Schichten (6) und (8) jeweils an die Zusammensetzung dieser Schichten angenähert ist.

21. Verfahren nach Anspruch 14 und mindestens einem der Ansprüche 13 bis 20, wobei die Schichtdicke der Übergangsschicht im Bereich von 0,1 nm bis 20 nm, bevorzugt 0,5 nm bis 10 nm und besonders bevorzugt 2 nm bis 10 nm liegt.

22. Verfahren nach mindestens einem der Ansprüche 13 bis 21, wobei das vorbeschichtete Substrat (10) in einer Förderrichtung gefördert wird, so dass dessen Oberfläche die Beschichtungsbereiche B1 (11) und B2 (12) der Beschichtungsprozesse sowie den Bereich B3 (13) durchläuft, in dem sich die beiden Bereich B1 (11) und B2 (12) überschneiden, wobei das vorbeschichtete Substrat (10) vorzugsweise mit einer konstanten Geschwindigkeit gefördert wird.

23. Verfahren nach mindestens einem der Ansprüche 13 bis 22, wobei die Beschichtungsprozesse P1 und P2 während der Beschichtung des vorbeschichteten Substrates (10) dauerhaft in Betrieb sind und der Gesamtprozess im wesentlichen stationär ist.

24. Verfahren nach mindestens einem der Ansprüche 13 bis 23, wobei die in der Beschichtungsebene liegenden Beschichtungsbereiche B1 (11) und B2 (12) jeweils eine längliche, verrundete Geometrie aufweisen, und die Ausdehnung dieser Beschichtungsbereiche B1 (11) und B2 (12) quer zur Förderrichtung im wesentlichen der Ausdehnung des vorbeschichteten Substrates (10) quer zur Förderrichtung entspricht.

25. Verfahren nach mindestens einem der Ansprüche 13 bis 24, wobei der Bereich B3 (13) ebenfalls eine längliche, verrundete Geometrie aufweist, und die Ausdehnung dieses Bereichs B3 (13) quer zur Förderrichtung im wesentlichen der Ausdehnung des vorbeschichteten Substrates (10) quer zur Förderrichtung entspricht.

26. Verfahren nach mindestens einem der Ansprüche 13 bis 25, wobei die Beschichtungsprozesse P1 und P2 innerhalb einer evakuierbaren Prozesskammer durchgeführt werden.

27. Verfahren nach mindestens einem der Ansprüche 13 bis 26, wobei es sich bei einem oder beiden Beschichtungsprozessen P1 und P2 um einen PVD (Physical Vapour Deposition)-Prozess handelt, bevorzugt um Magnetronsputtern.

28. Verfahren nach mindestens einem der Ansprüche 13 bis 27, wobei als Sputtergas ein Edelgas oder ein Edelgasgemisch eingesetzt wird.

29. Verfahren nach Anspruch 14 und mindestens einem der Ansprüche 13 bis 28, wobei die Beschichtungsbereiche B1 (11) und B2 (12) im wesentlichen übereinstimmen, und die metallische Haftschicht (6), die Zwischenschicht (7) und die Ag-haltige Reflektorschicht (8) durch eine zeitliche Abfolge der Beschichtungsprozesse P1 und P2 mit einer zeitlichen Überlappung erzeugt werden.
